# EUROPÄISCHE PATENTSCHRIFT

(11) **EP 1 038 357 B1**
(45) Veröffentlichungstag und Bekanntmachung des Hinweises auf die Patenterteilung: **23.03.2005**
(21) Anmeldenummer: 99960778.1
(22) Anmeldetag: 15.10.1999
(51) Int. Cl.: H03M 1/00

(54) **A/D-WANDLER**
A/D CONVERTER
NUMERISEUR

(30) Priorität: 15.10.1998 DE 19847662
(43) Veröffentlichungstag der Anmeldung: 27.09.2000
(73) Patentinhaber: Infineon Technologies AG, 81669 München (DE)
(72) Erfinder: BARRENSCHEEN, Jens, D-81669 München (DE); FENZL, Gunther, D-85635 Höhenkirchen-Siegertsbrunn (DE); ROHM, Peter, D-85276 Pfaffenhofen (DE); KÖNIG, Dietmar, D-81543 München (DE); EIKEMEIER, Dirk, D-38678 Clausthal-Zellerfeld (DE)
(74) Vertreter: Jannig, Peter, Dipl.-Ing.
(86) Internationale Anmeldenummer: PCT/DE1999/003320
(87) Internationale Veröffentlichungsnummer: WO 2000/022734

(56) Entgegenhaltungen:
- EP-A- 0 474 025
- JP-A- 59 211 132
- US-A- 5 703 583
- VON DER AHE U: "BUSFAEHIGE ANALOG-/DIGITALWANDLER" UND- ODER- NOR + STEUERUNGSTECHNIK,DE,DISTRIBUTION VERLAG GMBH. MAINZ, Bd. 26, Nr. 1 / 02, 1. Januar 1993 (1993-01-01), Seiten 24-25, XP000336583

## Beschreibung

Die vorliegende Erfindung betrifft eine Vorrichtung gemäß dem Oberbegriff des Patentanspruchs 1, d.h. einen A/D-Wandler.

A/D-Wandler (Analog/Digital-Wandler) dienen, wie die Bezeichnung schon andeutet, zur Wandlung analoger Signale in digitale Signale. Sie sind seit vielen Jahren in unzähligen Ausführungsformen bekannt, beispielsweise aus Von der Ahe U: Busfähige Analog-/Digitalwandler" UND- oder- NOR + Steuerungstechnik, DE, Distribution Verlag GmbH, Mainz, Bd. 26, Nr. 1 / 02, 1. Januar 1993, Seiten 24 - 25, XP000336583 beschrieben.

Mitunter ist es erforderlich, genau gleichzeitig (absolut zeitsynchron) erfaßte Spannungspegel mehrerer Analogsignale zu kennen. Dies ist beispielsweise erforderlich, um die Phasenströme von Elektromotoren genau wunschgemäß einstellen (regeln) zu können, oder um nach dem Resolverprinzip erfolgende Positionserfassungen durchführen zu können.

Steht für die zeitsynchrone Erfassung mehrerer Analogsignale nur ein A/D-Wandler zu Verfügung, so kann sie (die zeitsynchrone Erfassung der mehreren Analogsignale) durch Vorsehen mehrerer Sample- und Holdglieder (S&H-Glieder) bewerkstelligt werden. Die zeitsynchron zu erfassenden Analogsignale können durch die mehreren S&H-Glieder gleichzeitig abgetastet und (durch den einen A/D-Wandler) seriell A/Dgewandelt werden. Das Vorsehen, die Ansteuerung und die Koordination des A/D-Wandlers und der mehreren S&H-Glieder ist jedoch mit einem nicht unerheblichen Aufwand verbunden.

Eine denkbare Alternative hierzu besteht im Vorsehen mehrerer A/D-wandler. Dadurch können die zu erfassenden Analogsignale nicht nur zeitsynchron abgetastet, sondern auch noch gleich zeitsynchron gewandelt werden. Insbesondere wenn die die A/D-Wandler steuernde Einheit eine programmgesteuerte Einheit wie beispielsweise ein Mikroprozessor oder ein Mikrocontroller ist, erweist es sich jedoch als äußerst schwierig, die mehreren A/D-Wandler exakt zeitgleich zu starten. Zwischen dem Absetzen einer A/D-Wandlungsanforderung an einen ersten A/D-Wandler und dem Absetzen einer A/D-Wandlungsanforderung an einen zweiten A/D-Wandler liegen nämlich im allgemeinen mehrere Taktperioden der programmgesteuerten Einheit. Wenn die programmgesteuerte Einheit zwischen dem Absetzen der A/D-Wandlungsanforderungen an die verschiedenen A/D-Wandler auf einen Interrupt reagieren (eine Interrupt Service Routine ausführen) muß, wird die zeitliche Differenz zwischen dem Absetzen der A/D-Wandlungsanforderungen an die verschiedenen A/D-Wandler noch viel größer. Damit kann nicht einmal ein nur annähernd zeitgleicher Start der mehreren A/D-Wandler gewährleistet werden.

Der vorliegenden Erfindung liegt daher die Aufgabe zugrunde, eine Möglichkeit zu finden, durch die es mit minimalem Aufwand möglich ist, mehrere A/D-Wandler zuverlässig genau gleichzeitig zu starten.

Diese Aufgabe wird erfindungsgemäß durch den in Patentanspruch 1 beanspruchten A/D-Wandler gelöst.

Der erfindungsgemäße A/D-Wandler zeichnet sich dadurch aus, daß er dazu ausgelegt ist, den Beginn oder den bevorstehenden Beginn einer A/D-Wandlung zu signalisieren.

Dadurch ist es möglich, daß mehrere A/D-Wandler miteinander kooperieren können. Die Signalisierung des Beginns oder des bevorstehenden Beginns einer A/D-Wandlung ermöglicht es insbesondere, daß sich die mehreren A/D-Wandler selbständig, d.h. ohne Mitwirkung einer übergeordneten Steuereinrichtung so untereinander synchronisieren, daß sie bei Bedarf exakt zeitsynchron arbeiten.

Vorteilhafte Weiterbildungen der Erfindung sind den Unteransprüchen, der folgenden Beschreibung und der Figur entnehmbar.

Die Erfindung wird nachfolgend anhand eines Ausführungsbeispiels unter Bezugnahme auf die Figur näher erläutert.

Die Figur zeigt den Aufbau und die Kopplung von zwei A/D-Wandlern der nachfolgend näher beschriebenen Art.

Der nachfolgend näher beschriebene A/D-Wandler ist einer von zwei im wesentlichen identischen A/D-Wandlern eines Mikrocontrollers.

Es sei jedoch bereits an dieser Stelle darauf hingewiesen, daß auf einen derartigen Einsatz des A/D-Wandlers keine Einschränkung besteht: Der Mikrocontroller kann grundsätzlich eine beliebige Anzahl von A/D-Wandlern der nachfolgend beschriebenen Art enthalten, und A/D-Wandler der nachfolgend beschriebenen Art können auch außerhalb von Mikrocontrollern (in anderen Einrichtungen oder als separate, einen oder mehrere A/D-Wandler umfassende A/D-Wandler-Module) eingesetzt werden.

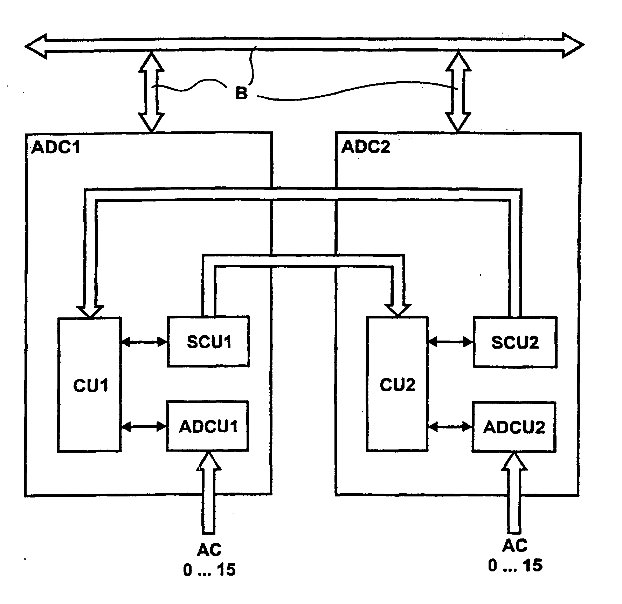

Der die A/D-Wandler enthaltende Teil des Mikrocontrollers ist schematisch in Figur 1 dargestellt.

Die A/D-Wandler sind in der Figur 1 mit dem Bezugszeichen ADC1 und ADC2 bezeichnet.

Die-A/D-Wandler ADC1 und ADC2 sind, wie vorstehend bereits erwähnt wurde, identisch aufgebaut. Sie enthalten jeweils eine A/D-Wandlungseinheit ADCU1 bzw. ADCU2, eine die A/D-Wandlungseinheit ADCU1 bzw. ADCU2 steuernde Steuereinheit CU1 bzw. CU2, und eine zur Synchronisierung des betreffenden A/D-Wandlers mit anderen A/D-Wandlern oder sonstigen Einrichtungen vorgesehene und mit der Steuereinheit CU1 bzw. CU2 kooperierende Synchronisations-Steuereinheit SCU1 bzw. SCU2.

Wie die Bezeichnung der Bestandteile der A/D-Wandler ADC1 und ADC2 bereits vermuten läßt, findet die eigentliche A/D-Wandlung in den A/D-Wandlungseinheiten ADCU1 bzw. ADCU2 statt. Im betrachteten Beispiel kann durch jede der A/D-Wandlungseinheiten eines von 16 verschiedenen Analogsignalen gewandelt werden; die die Analogsignale führenden Einrichtungen werden als Analogkanäle AC 0 ... 15 bezeichnet.

Die A/D-Wandler ADC1 und ADC2 können völlig unabhängig voneinander arbeiten; über die ihnen zugeordneten Analogkanäle AC 0 ... 15 können ihnen die selben oder verschiedene Analogsignale zugeführt werden.

Die A/D-Wandler ADC1 und ADC2 können von der CPU des Mikrocontrollers über einen internen Bus B unabhängig voneinander gestartet werden. Worin eine den Start des A/D-Wandlers auslösende A/D-Wandlungsanforderung im einzelnen besteht, spielt vorliegend keine Rolle. Unabhängig davon können dem zu startenden A/D-Wandler mit jeder A/D-Wandlungsanforderung die angeforderte A/D-Wandlung betreffende Informationen wie insbesondere die Nummer des der A/D-Wandlung zu unterziehenden Analogkanals, die bei der A/D-Wandlung zu verwendende Auflösung, und/oder Steuerinformationen für einen oder mehreren Multiplexer, die einem oder mehreren Analogkanälen vorgeschaltet sind, übermittelt werden.

Auf eine solche A/D-Wandlungsanforderung hin leitet der betreffende A/D-Wandler sofort oder später die angeforderte A/D-Wandlung ein. Unter welchen Voraussetzungen, wann und wie die geforderte A/D-Wandlung auszuführen ist, wird durch die mit der A/D-Wandlungsanforderung übertragenen Informationen und/oder den Inhalt von im A/D-Wandler enthaltenen kanalspezifischen Steuerregistern bestimmt.

Für jeden Analogkanal ist ein eigenes kanalspezifisches Steuerregister vorhanden. In diesen kanalspezifischen Steuerregistern ist beispielsweise gespeichert, wie lange das über den betreffenden Analogkanal erhaltene Analogsignal abzutasten ist, bevor mit der A/D-Wandlung zu beginnen ist.

Die A/D-Wandler ADC1 und ADC2 können, wie vorstehend bereits erwähnt wurde, völlig unabhängig voneinander betrieben werden. Sie sind darüber hinaus aber auch in der Lage, sich gegenseitig zu synchronisieren. Sie können sich bei Bedarf selbständig in eine Synchron-Betriebsart versetzen, in welcher sie vorbestimmte A/D-Wandlungen absolut zeitgleich bzw. zeitsynchron durchführen.

Das Umschalten in die bzw. aus der Synchron-Betriebsart erfolgt durch die A/D-Wandler selbst. Das das Umschalten in die Synchron-Betriebsart auslösende Ereignis besteht in einer A/D-Wandlungsanforderung an einen der A/D-Wandler, auf welche hin dieser ein Analogsignal eines Analogkanals wandeln soll, für den festgelegt ist, daß eine angeforderte A/D-Wandlung zeitsynchron mit einer anderen A/D-Wandlung zu erfolgen hat. Für welche Analogkanäle zeitsynchrone A/D-Wandlungen zu erfolgen haben, ist im betrachteten Beispiel in den vorstehend bereits erwähnten kanalspezifischen Steuerregistern festgelegt. Die kanalspezifischen Steuerregister enthalten im betrachteten Beispiel ein Bit oder ein Bitfeld, in welchem voreinstellbar ist, ob die A/D-Wandlung des am betreffenden Analogkanal anliegenden Analogsignals zeitsynchron mit der A/D-Wandlung eines an einem anderen Analogkanal (einem bestimmten Analogkanal des anderen A/D-Wandlers) anliegenden anderen Analogsignals zu erfolgen hat oder nicht.

Obgleich hierauf keine Einschränkung besteht, ist im betrachteten Beispiel festgelegt, daß die Nummern der Analogkanäle, die durch die mehreren A/D-Wandler einer zeitsynchronen A/D-Wandlung zu unterziehen sind, gleich sind. Da die Analogkanäle verschiedener A/D-Wandler unterschiedliche Analogsignale führen (können), werden dadurch nicht oder allenfalls in Ausnahmefällen identische Analogsignale gewandelt werden.

Bei von der CPU des Mikrocontrollers erhaltenen A/D-Wandlungsanforderungen überprüfen die A/D-Wandler durch Nachsehen in den kanalspezifischen Steuerregistern, ob von der A/D-Wandlungsanforderung ein Analogkanal betroffen ist, dessen Analogsignal zeitsynchron mit einem anderen Analogsignal zu wandeln ist.

Ist dies nicht der Fall, kann im betreffenden A/D-Wandler eine ganz "normale" A/D-Wandlung erfolgen.

Stellt ein A/D-Wandler hingegen fest, daß die A/D-Wandlung des Analogsignals des ausgewählten Analogkanals zeitsynchron mit der A/D-Wandlung eines Analogsignal eines anderen Analogkanals erfolgen soll, so versetzt sich der betreffende A/D-Wandler in die Synchron-Betriebsart und nimmt dabei einen Master-Status ein. Der betreffende A/D-Wandler wird seiner Funktion entsprechend nachfolgend als Master-A/D-Wandler bezeichnet; der andere A/D-Wandler nimmt nach dessen noch erläuterter Versetzung in die Synchron-Betriebsart einen Slave-Status ein und wird daher nachfolgend als Slave-A/D-Wandler bezeichnet. Es sei bereits an dieser Stelle darauf hingewiesen, daß die A/D-Wandler ADC1 und ADC2 absolut gleichberechtigt sind, also abwechselnd Master- und Slave-A/D-Wandler sein können.

Der Master-A/D-Wandler versendet nach dem Eintritt in die Synchron-Betriebsart an den anderen, zu diesem Zeitpunkt noch in der Normal-Betriebsart befindlichen A/D-Wandler eine (zu injizierende) A/D-Wandlungsanforderung, durch welche der andere A/D-Wandler zur Ausführung der zeitsynchron auszuführenden A/D-Wandlung veranlaßt werden soll. Mit dem Erhalt dieser A/D-Wandlungsanforderung wird der andere A/D-Wandler ebenfalls in die Synchron-Betriebsart versetzt, nimmt dabei allerdings den vorstehend bereits erwähnten Slave-Status ein und wird dadurch zum Slave-A/D-Wandler.

Die vom Master-A/D-Wandler abgesetzte A/D-Wandlungsanforderung enthält im betrachteten Beispiel Informationen und Anweisungen über die im Slave-A/D-Wandler auszuführende A/D-Wandlung, insbesondere
- Anweisungen über die Art und Weise der Injektion der durch den Master-A/D-Wandler angeforderten A/D-Wandlung in den Slave-A/D-Wandler-Betrieb,
- die Nummer des der A/D-Wandlung zu unterziehenden Analogkanals,
- die bei der A/D-Wandlung zu verwendende Auflösung, und/oder
- Steuerinformationen für einen oder mehreren Multiplexer, die einem oder mehreren Analogkanälen des Slave-A/D-Wandlers vorgeschaltet sind.

Die Anweisung über die Art und Weise der Injektion der durch den Master-A/D-Wandler angeforderten A/D-Wandlung in den Slave-A/D-Wandler-Betrieb legt fest, wie der Slave-A/D-Wandler die zu injizierende A/D-Wandlungsanforderung handhaben soll. Im betrachteten Beispiel kann diese Anweisung eine sogenannte Sync-Wait-Anweisung oder eine sogenannte Sync-Repeat-Anweisung sein.

Eine Sync-Wait-Anweisung veranlaßt den Slave-A/D-Wandler dazu, mit der Ausführung der durch den Master-A/D-Wandler angeforderten A/D-Wandlung zu warten, bis eine gerade laufende A/D-Wandlung beendet ist.

Eine Sync-Repeat-Anweisung veranlaßt den Slave-A/D-Wandler dazu, mit der Ausführung der durch dem Master-A/D-Wandler angeforderten A/D-Wandlung sofort zu beginnen; eine gerade laufende A/D-Wandlung ist zu abzubrechen und nach der Ausführung der durch den Master-A/D-Wandler angeforderten A/D-Wandlung erneut auszuführen.

Der Master-A/D-Wandler wartet nach dem Absetzen der A/D-Wandlungsanforderung an den Slave-A/D-Wandler auf eine Reaktion des Slave-A/D-Wandlers, genauer gesagt auf die Übermittlung eines Signals oder eine Signalfolge, durch welche dem Master-A/D-Wandler signalisiert wird, daß der Slave-A/D-Wandler mit der Ausführung der vom Master-A/D-Wandler angeforderten A/D-Wandlung soeben begonnen hat oder gerade beginnt oder gleich beginnen wird.

Sobald der Slave-A/D-Wandler mit der Ausführung der durch den Master-A/D-Wandler angeforderten A/D-Wandlung beginnt oder unmittelbar bevor der Slave-A/D-Wandler mit der Ausführung der durch den Master-A/D-Wandler angeforderten A/D-Wandlung beginnt, signalisiert der Slave-A/D-Wandler dieses erfolgte oder bevorstehende Ereignis dem Master-A/D-Wandler.

Vorzugsweise wird durch den Slave-A/D-Wandler der bevorstehende Beginn der durch den Master-A/D-Wandler angeforderten A/D-Wandlung signalisiert, wobei der tatsächliche Beginn der A/D-Wandlung zu einem Zeitpunkt erfolgt, der eine definierte Zeit nach der Signalisierung des bevorstehenden Beginns der A/D-Wandlung liegt, und wobei die definierte Zeit vorzugsweise genau so lange ist wie die Zeit, die der Master-A/D-Wandler benötigt, um auf die Signalisierung des bevorstehenden Beginns der von ihm angeforderten A/D-Wandlung zu reagieren und seinerseits mit der von der CPU des Mikrocontrollers angeforderten A/D-Wandlung zu beginnen. Dann wird mit der Ausführung der zeitsynchron auszuführenden A/D-Wandlungen exakt zeitsynchron (taktsynchron) begonnen.

Die CPU des Mikrocontrollers wird durch die Einleitung und Ausführung der zeitsynchron auszuführenden A/D-Wandlungen nur minimal belastet. Sie muß lediglich an einen der zeitsynchron zu betreibenden A/D-Wandler ADC1 und ADC2 eine A/D-Wandlungsanforderung absetzen. Den Rest erledigen die A/D-Wandler ADC1 und ADC1 alleine: sie synchronisieren sich ohne Mitwirkung der CPU des Mikrocontrollers durch ein einfaches Handshake-Verfahren selbst, so daß sie im Ergebnis exakt gleichzeitig oder mit minimalem zeitlichen Versatz mit der Ausführung der zeitsynchron auszuführenden A/D-Wandlungen beginnen. Die CPU des Mikrocontrollers muß dem zweiten A/D-Wandler nicht einmal mitteilen, welchen Analogkanal dieser einer A/D-Wandlung zu unterziehen hat und/oder unter Verwendung welcher Parameter dies zu geschehen hat; dies erfolgt durch den A/D-Wandler, von dem die CPU die Ausführung einer der zeitsynchron durchzuführenden A/D-Wandlungen angefordert hat.

Nach der Ausführung der zeitsynchron auszuführenden A/D-Wandlungen verlassen die A/D-Wandler die Synchron-Betriebsart selbständig und werden dadurch automatische wieder die unabhängig betreibbaren und arbeitenden A/D-Wandler, die sie vor dem Eintritt in die Synchron-Betriebsart waren.

Um einen unter allen Umständen störungsfreien Betrieb der A/D-Wandler ADC1 und ADC2 gewährleisten zu können, ist es erforderlich, einige Sonderfälle zu berücksichtigen.

Einer dieser Sonderfälle besteht darin, daß der Master-A/D-Wandler nach der Anforderung einer A/D-Wandlung vom Slave-A/D-Wandler, aber noch vor dem Erhalt der Meldung über den erfolgten oder bevorstehenden Beginn der Ausführung der angeforderten A/D-Wandlung eine weitere A/D-Wandlungsanforderung von der CPU des Mikrocontrollers empfängt. In diesem Fall muß der Master-A/D-Wandler zunächst überprüfen, welche der von ihm angeforderten A/D-Wandlungen die höhere Priorität hat. Ist es die ältere (gerade in Bearbeitung befindliche) A/D-Wandlungsanforderung, die die höhere Priorität hat, so wird mit der Ausführung der neueren A/D-Wandlungsanforderung gewartet, bis die ältere (gerade in Bearbeitung befindliche) A/D-Wandlungsanforderung ausgeführt ist. Ist es hingegen die neuere A/D-Wandlungsanforderung, die die höhere Priorität hat, so muß die Bearbeitung der älteren A/D-Wandlungsanforderung abgebrochen und nach der Ausführung der neueren A/D-Wandlungsanforderung automatisch erneut zur Ausführung gebracht werden. Zum Abbruch der Bearbeitung der älteren A/D-Wandlungsanforderung gehört es, daß der Master-A/D-Wandler den Slave-A/D-Wandler durch Übermittlung entsprechender Daten und/oder Signale aus der durch die A/D-Wandlungsanforderung seitens des Master-A/D-Wandlers eingeleiteten Synchron-Betriebsart in die "normale" Betriebsart zurücksetzt und dann selbst die Synchron-Betriebsart verläßt.

Ein weiterer Sonderfall besteht darin, daß der Slave-A/D-Wandler vor dem Beginn oder während der Abarbeitung einer vom Master-A/D-Wandler angeforderten A/D-Wandlung eine höherpriorisierte A/D-Wandlungsanforderung von der CPU des Mikrocontrollers erhält. Dies könnte zu längeren Unterbrechungen oder Verzögerungen der Ausführung der vom Master-A/D-Wandler angeforderten A/D-Wandlung führen. Diesem Sonderfall wird im vorliegend betrachteten Beispiel dadurch begegnet, daß der vom Master-A/D-Wandler angeforderten A/D-Wandlung die höchstmögliche Priorität zugeordnet wird. Damit werden übermäßige Unterbrechungen oder Verzögerungen der Ausführung der vom Master-A/D-Wandler angeforderten A/D-Wandlung und die damit verbundenen Komplikationen vermieden.

Ein weiterer Sonderfall besteht darin, daß sich beide A/D-Wandler in den Master-Status versetzt haben und nun im wesentlichen gleichzeitig vom jeweils anderen A/D-Wandler die Durchführung einer A/D-Wandlung anfordern. Diesem Sonderfall wird im betrachteten Beispiel dadurch begegnet, daß die A/D-Wandler den Master-Status in Konfliktsituationen jederzeit selbständig verlassen können. Die Bedingungen, unter denen ein A/D-Wandler den Master-Status außerplanmäßig verläßt (verlassen muß), können grundsätzlich beliebig sein. Welcher der A/D-Wandler den Master-Status im Konfliktfall zu verlassen hat, hängt im betrachteten Beispiel von der zeitlichen Aufeinanderfolge der gegenseitigen A/D-Wandlungsanforderungen (wer früher anfordert, erhält den Vorrang) und - sofern sich basierend darauf keine Entscheidung treffen läßt - von den Nummern der Analogkanäle ab, die den jeweiligen A/D-Wandlungen zu unterziehen sind (wer den Analogkanal mit der höheren Nummer einer A/D-Wandlung unterziehen bzw. unterzogen haben will, erhält den Vorrang).

Die beschriebenen A/D-Wandler sind in verschiedenerlei Hinsicht modifizierbar.

So ist es beispielsweise möglich, daß der Master-A/D-Wandler den vorstehend bereits erwähnten Sync-Repeat-Modus anordnet und eine vorbestimmte Zeit nach dem Absetzen der A/D-Wandlungsanforderung, also ohne Abwarten der Reaktion des Slave-A/D-Wandlers, mit der Ausführung der durch ihn auszuführenden A/D-Wandlung beginnt. Auch hierdurch lassen sich mehrere A/D-Wandlungen zeitsynchron durchführen. Durch den Sync-Repeat-Modus wird der Slave-A/D-Wandler ja angewiesen, die angeforderte A/D-Wandlung sofort (gegebenenfalls unter Abbrechen einer gerade laufenden A/D-Wandlung) durchzuführen, wodurch der Beginn der A/D-Wandlung durch den Slave-A/D-Wandler auch ohne Signalisierung des Beginns oder des bevorstehenden Beginns der A/D-Wandlung bekannt sein kann.

Umgekehrt können die Kommunikation und der Handshake zwischen den A/D-Wandlern natürlich auch beliebig umfangreicher gestaltet werden.

A/D-Wandlere der vorstehend beschriebenen Art können nicht nur miteinander, sondern auch mit beliebigen anderen Einrichtungen (beispielsweise anderen Peripherieeinheiten des Mikrocontrollers) wie beschrieben kooperieren (selbständig Synchron laufend betrieben werden).

Wie vorstehend beschrieben oder ähnlich aufgebaute und betreibbare A/D-Wandler ermöglichen es unabhängig von den Einzelheiten deren praktischer Realisierung, daß zeitsynchron vorzunehmende Operationen unter minimaler Belastung übergeordneter Steuereinrichtungen genau zeitsynchron durchführbar sind.

In einer Weiterbildung der Erfindung müssen bei zunehmend komplexeren Applikationen häufig verschiedene Eingangssignale AD-gewandelt werden, wobei es hier dazu kommen kann, daß zwei oder mehrere Analogkanäle absolut synchron mit unterschiedlichen Abtastraten abgetastet werden müssen. Insbesondere bei Anwendungen in der Telekommunikation bzw. beim Erfassen von Audiosignalen ist es häufig erforderlich, daß beispielsweise zwei oder mehrere Analogkanäle mit unterschiedlichen Abtastraten abgetastet werden müssen, um sie zur Weiterverarbeitung vorzubereiten. Dieses Problem wurde bislang durch Verwendung von zwei oder mehreren Abtasthaltegliedern (sogenannten Sample-and-Hold-Glieder; S&H) oder mehreren externen unabhängigen AD-Wandlerbausteinen realisiert. Jedoch ist diese Lösung zum einen schaltungstechnisch sehr aufwendig und zum anderen benötigt diese Wandlung zusätzliche Rechenleistung der zentralen Recheneinheit (CPU) der die Wandlung steuernden programmgesteuerten Einheit.

Durch die vorliegende Erfindung wird das Problem von kollidierender Anforderungen unterschiedlicher Quellen folgendermaßen gelöst: Die Verwendung mehrerer baugleicher AD-Wandlermodule kombiniert mit Zeitgebereinheiten gestattet es, eine synchrone Wandlung mehrerer Kanäle mit mehreren unterschiedlichen Frequenzen anzufordern und durchzuführen. Diese Anforderung und Wandlung erfordert vorteilhafterweise keine zusätzliche Rechenleistung der zentralen Recheneinheit (CPU). Das Problem kollidierender Anforderungssignale der einzelnen Anforderungsquellen wird mit Hilfe eines deterministischen Priorisierungsverfahrens, zum Beispiel über Kanalnummern, gelöst.

### Bezugszeichenliste

- AC 0...15: Analogkanäle
- ADCUx: A/D-Wandlungseinheiten
- ADCx: A/D-Wandler
- B: interner Bus des Mikrocontrollers
- CUx: Steuereinheiten
- SCUx: Synchronisations-Steuereinheiten

## Patentansprüche

1. A/D-Wandler,
**dadurch gekennzeichnet,**
**daß** dieser dazu ausgelegt ist, den Beginn oder den bevorstehenden Beginn einer A/D-Wandlung zu signalisieren.

2. A/D-Wandler nach Anspruch 1,
**dadurch gekennzeichnet,**
**daß** dieser dazu ausgelegt ist, von einem anderen A/D-Wandler die Durchführung einer A/D-Wandlung anzufordern.

3. A/D-Wandler nach Anspruch 2,
**dadurch gekennzeichnet,**
**daß** dieser dazu ausgelegt ist, vor der Durchführung einer von ihm angeforderten A/D-Wandlung zu überprüfen, ob die angeforderte A/D-Wandlung zeitsynchron mit einer weiteren A/D-Wandlung durchzuführen ist.

4. A/D-Wandler nach Anspruch 3,
**dadurch gekennzeichnet,**
**daß** in diesem voreinstellbar ist, welche A/D-Wandlungen zeitsynchron mit anderen A/D-Wandlungen zu erfolgen haben.

5. A/D-Wandler nach einem der Ansprüche 2 bis 4,
**dadurch gekennzeichnet,**
**daß** dieser dazu ausgelegt ist, vom anderen A/D-Wandler die Durchführung einer A/D-Wandlung anzufordern, die zeitsynchron mit einer von ihm angeforderten A/D-Wandlung durchzuführen ist.

6. A/D-Wandler nach Anspruch 5,
**dadurch gekennzeichnet,**
**daß** dieser dazu ausgelegt ist, die Anforderung der zeitsynchron durchzuführenden A/D-Wandlung vom anderen A/D-Wandler vorzunehmen, bevor er mit der Ausführung der von ihm angeforderten A/D-Wandlung beginnt.

7. A/D-Wandler nach Anspruch 5 oder 6,
**dadurch gekennzeichnet,**
**daß** dieser dazu ausgelegt ist, mit der Ausführung der von ihm auszuführenden A/D-Wandlung zu warten, bis der andere A/D-Wandler, von dem er die Durchführung der zeitsynchron durchzuführenden A/D-Wandlung angefordert hat, den Beginn oder den bevorstehenden Beginn der angeforderten A/D-Wandlung signalisiert.

8. A/D-Wandler nach einem der Ansprüche 2 bis 7,
**dadurch gekennzeichnet,**
**daß** dieser dazu ausgelegt ist, dem anderen A/D-Wandler Informationen darüber zukommen zu lassen, wie die angeforderten A/D-Wandlungen handzuhaben sind.

9. A/D-Wandler nach Anspruch 8,
**dadurch gekennzeichnet,**
**daß** dieser dazu ausgelegt ist, den anderen A/D-Wandler anzuweisen, die Ausführung der angeforderten A/D-Wandlung sofort zu beginnen.

10. A/D-Wandler nach Anspruch 9,
**dadurch gekennzeichnet,**
**daß** dieser dazu ausgelegt ist, den anderen A/D-Wandler anzuweisen, eine gerade laufende A/D-Wandlung abzubrechen und nach der Ausführung der angeforderten A/D-Wandlung erneut auszuführen.

11. A/D-Wandler nach Anspruch 8,
**dadurch gekennzeichnet,**
**daß** dieser dazu ausgelegt ist, den anderen A/D-Wandler anzuweisen, mit der Ausführung der angeforderten A/D-Wandlung zu warten, bis eine gerade laufende A/D-Wandlung beendet ist.

12. A/D-Wandler nach einem der Ansprüche 2 bis 11,
**dadurch gekennzeichnet,**
**daß** die A/D-Wandlungen, die der A/D-Wandler von einem anderen A/D-Wandler anfordert, mit höchster Priorität versehen sind.

13. A/D-Wandler nach einem der vorhergehenden Ansprüche,
**dadurch gekennzeichnet,**
**daß** dieser dazu ausgelegt ist, von einem anderen A/D-Wandler stammende Wandlungsanforderungen zu akzeptieren.

14. A/D-Wandler nach einem der vorhergehenden Ansprüche,
**dadurch gekennzeichnet,**
**daß** dieser baugleich mit einem anderen A/D-Wandler ausgelegt ist, und daß mindestens eine Zeitgebereinheit vorgesehen ist, die eine Anforderung und eine synchrone Wandlung mehrerer Kanäle mit mehreren unterschiedlichen Frequenzen der baugleichen A/D-Wandler gestattet.

## Claims

1. A/D converter,
**characterized in that**
it is designed to signal the beginning or the imminent beginning of an A/D conversion.

2. A/D converter according to Claim 1,
**characterized in that**
it is designed to request another A/D converter to carry out an A/D conversion.

3. A/D converter according to Claim 2,
**characterized in that**
it is designed to check, before carrying out an A/D conversion requested of it, whether the requested A/D conversion is to be carried out synchronously, in terms of time, with a further A/D conversion.

4. A/D converter according to Claim 3,
**characterized in that**
it is possible to preset said A/D converter to determine the A/D conversions which have to be carried out synchronously, in terms of time, with other A/D conversions.

5. A/D converter according to one of Claims 2 to 4,
**characterized in that**
it is designed to request the other A/D converter to carry out an A/D conversion which is to be carried out synchronously, in terms of time, with an A/D conversion requested of it.

6. A/D converter according to Claim 5,
**characterized in that**
it is designed to request the A/D conversion (which is to be carried out synchronously in terms of time) of the other A/D converter before it begins to carry out the A/D conversion requested of it.

7. A/D converter according to Claim 5 or 6,
**characterized in that**
it is designed to wait until the other A/D converter, which it has requested to carry out the A/D conversion (which is to be carried out synchronously in terms of time), signals the beginning or the imminent beginning of the requested A/D conversion, before carrying out the A/D conversion to be carried out by it.

8. A/D converter according to one of Claims 2 to 7,
**characterized in that**
it is designed to provide the other A/D converter with information about the manner in which the requested A/D conversions are to be handled.

9. A/D converter according to Claim 8,
**characterized in that**
it is designed to instruct the other A/D converter to begin carrying out the requested A/D conversion immediately.

10. A/D converter according to Claim 9,
**characterized in that**
it is designed to instruct the other A/D converter to abort an A/D conversion that is currently in progress and to carry it out again after the requested A/D conversion has been carried out.

11. A/D converter according to Claim 8,
**characterized in that**
it is designed to instruct the other A/D converter to wait until an A/D conversion that is currently in progress has ended before carrying out the requested A/D conversion.

12. A/D converter according to one of Claims 2 to 11,
**characterized in that**
the A/D conversions which the A/D converter requests of another A/D converter are provided with the highest priority.

13. A/D converter according to one of the preceding claims,
**characterized in that**
it is designed to accept conversion requests which originate from another A/D converter.

14. A/D converter according to one of the preceding claims,
**characterized in that**
it is of the same design as another A/D converter, and **in that** at least one timer unit, which allows the A/D converters of the same design to request and synchronously convert a plurality of channels at a plurality of different frequencies, is provided.

## Revendications

1. Convertisseur A/N **caractérisé en ce que**
celui-ci est configuré pour signaler le début ou le début imminent d'une conversion A/N.

2. Convertisseur A/N selon la revendication 1,
**caractérisé en ce que** celui-ci est configuré pour demander l'exécution d'une conversion A/N par un autre convertisseur A/N.

3. Convertisseur A/N selon la revendication 2,
**caractérisé en ce que** celui-ci est configuré pour contrôler avant l'exécution d'une conversion A/N demandée par lui-même, si la conversion A/N demandée est à exécuter en synchronisme temporel avec une conversion A/N supplémentaire.

4. Convertisseur A/N selon la revendication 3,
**caractérisé en ce que** l'on peut prérégler dans celui-ci, les conversions A/N qui doivent se réaliser en synchronisme temporel avec d'autres conversions A/N.

5. Convertisseur A/N selon l'une quelconque des revendications 2 à 4, **caractérisé en ce que** celui-ci est configuré pour demander la réalisation d'une conversion A/N par l'autre convertisseur A/N, laquelle doit être exécutée en synchronisme temporel avec une conversion A/N demandée par lui-même.

6. Convertisseur A/N selon la revendication 5,
**caractérisé en ce que** celui-ci est configuré pour procéder à la demande de la conversion A/N à réaliser en synchronisme temporel par l'autre convertisseur A/N, avant qu'il ne commence l'exécution de la conversion A/N demandée par lui-même.

7. Convertisseur A/N selon la revendication 5 ou 6,
**caractérisé en ce que** celui-ci est configuré pour attendre avec l'exécution de la conversion A/N à exécuter par lui-même, jusqu'à ce que l'autre convertisseur A/N, auquel il a demandé l'exécution de la conversion A/N à exécuter en synchronisme temporel, signale le début ou le début imminent de la conversion A/N demandée.

8. Convertisseur A/N selon l'une quelconque des revendications 2 à 7, **caractérisé en ce que** celui-ci est configuré pour permettre à l'autre convertisseur A/N de recevoir des informations sur la façon dont doivent être appliquées les conversions A/N demandées.

9. Convertisseur A/N selon la revendication 8,
**caractérisé en ce que** celui-ci est configuré pour ordonner à l'autre convertisseur A/N, l'exécution immédiate de la conversion A/N demandée.

10. Convertisseur A/N selon la revendication 9,
**caractérisé en ce que** celui-ci est configuré pour ordonner à l'autre convertisseur A/N d'interrompre une conversion A/N en cours et de l'exécuter à nouveau après exécution de la conversion A/N demandée.

11. Convertisseur A/N selon la revendication 8,
**caractérisé en ce que** celui-ci est configuré pour ordonner à l'autre convertisseur A/N d'attendre, avec l'exécution de la conversion A/N demandée, jusqu'à ce qu'une conversion A/N en cours soit terminée.

12. Convertisseur A/N selon l'une quelconque des revendications 2 à 11, **caractérisé en ce que** les conversions A/N que demande le convertisseur A/N d'un autre convertisseur A/N, sont dotées de la priorité la plus élevée.

13. Convertisseur A/N selon l'une quelconque des revendications précédentes, **caractérisé en ce que** celui-ci est configuré pour accepter des demandes de conversion provenant d'un autre convertisseur A/N.

14. Convertisseur A/N selon l'une quelconque des revendications précédentes, **caractérisé en ce que** celui-ci est configuré de façon identique en construction avec un autre convertisseur A/N et qu'au moins une unité d'horloge est prévue qui permet une demande et une conversion synchrone de plusieurs canaux avec plusieurs fréquences différentes des convertisseurs A/N de construction identique.
